# EUROPÄISCHE PATENTSCHRIFT

(11) **EP 2 038 450 B1**
(45) Veröffentlichungstag und Bekanntmachung des Hinweises auf die Patenterteilung: **26.09.2012**
(21) Anmeldenummer: 07763737.9
(22) Anmeldetag: 05.07.2007
(51) Int. Cl.: C23C 14/34, C23C 14/08, H01M 8/12

(54) **VERFAHREN ZUR HERSTELLUNG EINER ELEKTRISCH LEITFÄHIGEN SCHICHT UND PORÖSES TRÄGERSUBSTRAT**
METHOD FOR PRODUCING AN ELECTRICALLY CONDUCTING LAYER AND POROUS CARRIER SUBSTRATE
PROCÉDÉ DE RÉALISATION D'UNE COUCHE ÉLECTROCONDUCTRICE ET SUBSTRAT DE SUPPORT POREUX

(30) Priorität: 07.07.2006 AT 5342006 U
(43) Veröffentlichungstag der Anmeldung: 25.03.2009
(73) Patentinhaber: PLANSEE SE, 6600 Reutte (AT)
(72) Erfinder: KAILER, Karl, 6600 Breitenwang (AT); KUNSCHERT, Georg, 6600 Pflach (AT); SCHLICHTHERLE, Stefan, 6632 Ehrwald (AT); STRAUSS, Georg, 6232 Münster (AT)
(86) Internationale Anmeldenummer: PCT/AT2007/000338
(87) Internationale Veröffentlichungsnummer: WO 2008/003113

(56) Entgegenhaltungen:
- US-A1- 2005 092 597
- US-B1- 6 455 326
- RUSKE ET AL: "Hydrogen doping of DC sputtered ZnO:Al films from novel target material" SURFACE AND COATINGS TECHNOLOGY, ELSEVIER, AMSTERDAM, NL, Bd. 200, Nr. 1-4, 1. Oktober 2005 (2005-10-01), Seiten 236-240, XP005063503 ISSN: 0257-8972
- CORATOLO ANTHONY ET AL: "Structural evolution of la0.9Sr0.1Cr 0.9Co0.1O3 thin films for SOFCs and catalysis" MATER RES SOC SYMP PROC; MATERIALS RESEARCH SOCIETY SYMPOSIUM PROCEEDINGS; NANOPARTICLES AND NANOSTRUCTURES IN SENSORS AND CATALYSIS 2005, Bd. 900, 2. Dezember 2005 (2005-12-02), Seiten 176-181, XP007903297 & JOHNSON CHRISTOPHER ET AL: "Perovskite based protective coatings for solid oxide fuel cell metallic interconnects" PROC. ELECTROCHEM. SOC.; PROCEEDINGS - ELECTROCHEMICAL SOCIETY; SOLID OXIDE FUEL CELLS IX, SOFC IX: MATERIALS - PROCEEDINGS OF THE INTERNATIONAL SYMPOSIUM 2005, Bd. PV 2005-07, 2005, Seiten 1842-1850, XP008085233
- KANG ET AL: "Thin-film solid oxide fuel cells on porous nickel substrates with multistage nanohole array", JOURNAL OF THE ELECTROCHEMICAL SOCIETY, ELECTROCHEMICAL SOCIETY. MANCHESTER, NEW HAMPSHIRE, US, vol. 153, no. 3, 1 January 2006 (2006-01-01), pages A554-A559, XP007917564, ISSN: 0013-4651, DOI: 10.1149/1.2164769

## Beschreibung

Die Erfindung betrifft ein Verfahren zur Herstellung einer elektrisch leitfähigen Schicht mit perowskitischer Struktur und ein Trügersulstrat.

Schutzschichten mit perowskitischer Struktur finden beispielsweise in Hochtemperatur-Brennstoffzellen (SOFC; Solid Oxide Fuel Cell) Verwendung. Diese werden bei Temperaturen von etwa 650 bis 900°C betrieben, da erst bei diesen Temperaturen die thermodynamischen Bedingungen für eine effiziente Energieerzeugung gegeben sind. Bei planaren SOFC-Systemen werden einzelne elektrochemische Zellen, die aus einer Kathode, einem Feststoffelektrolyten und einer Anode aufgebaut sind, zu einem so genannten Stack gestapelt und durch metallische Komponenten, so genannte Interkonnektoren verbunden.

Der Interkonnektor trennt auch die Anoden- und Kathodengasräume. Ein dichter Interkonnektor ist für einen hohen Wirkungsgrad einer Hochtemperaturbrennstoffzelle genauso wichtig, wie eine dichte Elektrolytschicht. Geeignete Werkstoffe für Interkonnektoren müssen zudem eine ausreichende Leitfähigkeit und Beständigkeit gegenüber den oxidierenden Bedingungen an der Luftseite und reduzierenden Bedingungen an der Brenngasseite aufweisen. Diese Anforderungen erfüllen derzeit am besten Lanthan-Chromit, Chrom-Eisenlegierungen, gedopt mit Yttriumoxid, und chromreiche Ferrite.

Um das Abdampfen von Chrom während des Einsatzes zu reduzieren, wird auf dem Interkonnektor eine leitfähige Schicht mit perowskitischer Struktur abgeschieden.

Perowskite, die heute für die Herstellung von Kathoden in der SOFC Verwendung finden, haben die Eigenschaft, je nach Art und Höhe der Dotierung Mischleiter zu sein, d.h. sie sind sowohl elektronen-, als auch ionenleitend. Perowskite sind auch bei hohen Sauerstoffpartialdrücken thermodynamisch stabil und werden zur Verbesserung der Kontaktierung auch auf der zur Kathode weisenden Seite des Interkonnektors aufgebracht.

Neben dem einfachen Bestreichen der Oberflächen mit perowskitische Keramik enthaltenden Kontaktpasten wurden Verfahren wie beispielsweise APS (Atmospheric Plasma Spraying), VPS (Vacuum Plasma Spraying), Dip Coating oder Wet Powder Spraying für die Beschichtung von Interkonnektoren evaluiert bzw. kommen semi-industriell zur Anwendung. Diese Sprühverfahren werden auch zur Herstellung von elektrochemisch aktiven Zellschichten in der Hochtemperaturbrennstoffzelle angewandt. VPS und APS sind Spritzverfahren, die entweder im Vakuum oder unter atmosphärischen Bedingungen durchgeführt werden. Es wird dabei im Plasmastrahl Pulver aufgeschmolzen, wobei die Pulverkörner beim Auftreffen auf der Substratoberfläche sofort fladenförmig mit einigen µm Dicke erstarren. Ein gewisser Anteil an Restporosität kann bei dieser Technik nicht verhindert werden. Um möglich gasdichte Strukturen zu erzielen, werden dicke Schichten mit Schichtdicken von rund 30 bis 50 µm abgeschieden. Es werden somit große Mengen an keramischem Material auf die Substratoberflächen aufgebracht, was zu entsprechend hohen Kosten führt. Hinzu kommt bei dicken Schichten eine Verringerung des Elektronendurchgangs. Auch die immer vorhandene Porosität reduziert die Elektronenleitfähigkeit.

Auch CVD Prozesse, ausgehend von chloridischen Verbindungen und Reaktion mit Wasserdampf bei Abscheidetemperaturen von 1100 bis 1300°C, wurden erprobt. Mit diesem Prozess wurden Schichten mit Dicken von 20 bis 50 µm hergestellt. Auch dieser Prozess ist kostenintensiv. Zudem sind die hohen Abscheidetemperaturen nachteilig.

Um die in der Vergangenheit aufgetretenen Probleme bei der Kontaktierung der Interkonnektoren besser in den Griff zu bekommen, wurden zudem neue planare SOFC Konzepte entwickelt; in jüngster Vergangenheit auch das so genannte MSC (Metal Supported Cell)-Konzept, bei dem elektrochemische Zellen direkt auf poröse Trägersubstrate aufgebracht werden. Diese porösen metallischen Trägersubstrate können sowohl an der Kathoden- als auch an der Anodenseite zum Einsatz kommen.

Anodenseitige MSC-Konzepte ermöglichen hohe Leistungsdichten und stellen eine kostengünstige Alternative dar.

Für MSC werden Anoden aus NiO-YSZ (Nickeloxid - Yttrium stabilisiertes Zirkonoxid) verwendet, die im unmittelbaren stofflichen Kontakt zum porösen metallischen Trägersubstrat stehen. Da diese Trägersubstrate üblicherweise aus einer Fe-Basis Legierung mit hohen Cr-Gehalten bestehen, kommt es bei Einsatztemperaturen von 650 bis 900°C zur Diffusion von Ni aus der Anode in das Trägersubstrat bzw. von Fe und Cr aus dem Trägersubstrat in die NiO-YSZ Anode. Dieses Phänomen der Interdiffusion hat zur Folge, dass es im Kontaktbereich zur Bildung einer Diffusionszone aus Fe-Cr-Ni kommt. Diese Diffusionszone hat im Vergleich zum Trägersubstrat einen deutlich höheren thermischen Ausdehnungskoeffizienten. Dies kann zu Abplatzungen führen, die eine starke Degradation oder Totalausfall zur Folge habe. Die Interdiffusion kann durch perowskitische Diffusionsbarrierschichten verhindert werden. Bis dato werden dazu poröse Schichten abgeschieden, da ansonsten die Gasdurchlässigkeit des Trägersubstrats nicht mehr gegeben ist. Plasmagespritzte Diffusionsbarrierschichten werden auch kathodenseitig auf Interkonnektoren aufgebracht. Hier ist nachteilig, dass aufgrund der intrinsisch hohen Porosität sehr dicke und damit teure Schichten zum Einsatz kommen.

Für metallische Eisen-Chrom Legierungen in Brennstoffzellen wurde vorgeschlagen, leitfähige keramische Perowskitschichten durch RF Magnetronsputtern aufzubringen (A. CORATOLO et AL "Structural evolution of La0.9Sr0.1 Cr 0.9Co0.1 O3 thin films for SOFCs and catalysis" in MATERIALS RESEARCH SOCIETY SYMPOSIUM PROCEEDINGS; NANOPARTICLES AND NANOSTRUCTURES IN SENSORS AND CATALYSIS 2005 BAND 900E, S. 176-181).

Dünne leitfähige Keramikschichten sind auch mittels gepulster Sputterprozesse keramischer Targets zugänglich (F. Ruske et al., SURFACE AND COATINGS TECHNOLOGY 200 (2005) 236-240).

Auch Perowskitschichten können mittels gepulster Sputterprozesse hergestellt werden (US6455326).

Auch im Zusammenhang mit Hochtemperatur-Brennstoffzellen sind gepulste Sputterprozesse bekannt (Journal of the Electrochemical Society, 153(3), A554-A559 (2006)).

Aufgabe der Erfindung ist daher die Bereitstellung eines Verfahrens, das zum einen ein kostengünstiges Herstellen von dünnen, dichten und elektrisch leitfähigen Keramikschichten ermöglicht,

Eine weitere Aufgabe der Erfindung ist es, eine leitfähige keramische Diffusionssperrschicht bereit zu stellen, die auf einem porösen Trägersubstrat aufgebracht, die Gasdurchlässigkeit des Trägersubstrats nicht wesentlich beeinträchtigt.

Die Aufgabe wird durch die unabhängigen Ansprüche gelöst. Dabei wird eine elektrisch leitfähige keramische Schicht, bevorzugt mit perowskitscher Struktur, durch einen gepulsten Sputterprozess abgeschieden. Mit dem erfindungsgemäßen Verfahren ist es möglich, dünne, dichte und funktionale keramische Schichten gleichmäßig auf die Oberfläche von dichten, aber auch porösen Substratwerkstoffen aufzubringen. Der Stofftransport durch die aufgebrachte Schicht ist auf Fehlstellenmechanismen beschränkt. Die Diffusivität von beispielsweise Chrom in der erfindungsgemäßaufgbrachten Schicht list auch bei Temperaturen über 600°C sehr gering. Damit ist es möglich, als Diffusionsbarrierschicht sehr dünne Schichen mit einer Dicke von vorzugsweise 0,1 bis 5 µm einzusetzen. Unter 0,1 µm ist die Barrierewirkung nicht ausreichend. Über 5 µm neigt die Schicht zum Abplatzen.

Die Verwendung von dünnen Schichten erhöht den Elektronendurchgang des Systems metallischer Interkonnektor / Schicht.

Wird die erfindungsgemäßaufgebrachte Schicht auf einem porösen Trägersubstrat aufgebracht, bildet sich keine geschlossene Deckschicht aus. Die überwiegend offenporige Struktur des Trägersubstrats bleibt damit erhalten. Das beschichtete Trägersubstrat weist damit gute Transport- und Kontaktierungseigenschaften auf. Das poröse Trägersubstrat weist eine Dichte von 40 bis 70 % der theoretischen Dichte auf und besteht bevorzugt aus miteinander versinterten Körnern einer Fe-Basis Legierung mit 15 bis 35 Gew.% Cr, 0,01 bis 2 Gew.% eines oder mehrerer Elemente der Gruppe Ti, Zr, Hf, Mn, Y, Sc, Seltenerdmetalle, 0 bis 10 Gew.% Mo und / oder Al, 0 bis 5 Gew.% eines oder mehrerer Metalle der Gruppe Ni, W, Nb, Ta und 0,1 bis 1 Gew.% O, mit Rest Fe und Verunreinigungen.

PVD Verfahren werden zur Beschichtung von Interkonnektoren mit keramischen Materialien nicht verwendet, da man bis dato davon ausging, dass reaktive PVD-Prozesse aufgrund ihrer schwierigen Prozessführung, für die Abscheidung von leitfähigen keramischen Schichten, im speziellen dielektrischen Schichten mit perowskitischer Struktur, nicht geeignet sind, da eine stöchiometrische Abscheidung des komplexen Schichtmaterials und die geforderten Schichteigenschaften, wie hohe Dichte und gute elektrische Leitfähigkeit, nicht erzielt werden können.

Beim Kathodenzerstäuben oder Sputtern wird die Schicht durch elektrisch neutrale Teilchen aufgebaut, welche verfahrensbedingt unterschiedliche Energien aufweisen. Das Beschichtungsmaterial befindet sich als so genanntes Target dem Substrat gegenüber. Beim Sputtern wird das Target mit positiven Ionen beschossen. Zwischen Substrat (-halter) und Target wird eine Spannung angelegt, so dass positive Ionen zum Target hin beschleunigt werden. Dort schlagen sie Atome oder Moleküle heraus, die sich dann als Neutralteilchen, vom äußeren Feld unbeeinflusst, auf dem Substrat absetzen und die dünne funktionelle Schicht bilden. Um die für den Sputterprozess benötigten positiven Ionen zu erzeugen, macht man sich das Prinzip einer selbständigen Glimmentladung zunutze. Der Raum zwischen Anode und Kathode wird evakuiert und anschließend mit dem Prozessgas gefüllt. Zwischen Anode und Kathode wird eine Spannung angelegt. In der Folge bilden sich im Wesentlichen drei Bereiche aus: der Kathodendunkelraum, eine quasineutrale Übergangszone und die positive Säule. Die Vorgänge zwischen Kathode und Anode lassen sich also in den folgenden Prozessen zusammenfassen: Ionisation von Gasatomen durch Elektronenstoß, ioneninduzierte Elektronenemission an der Kathode, elektroneninduzierte Sekundäremission an der Anode und Sputtern durch Ionenstoß.

Die Verwendung von gepulsten Sputterplasmen ermöglicht die Verwendung wesentlich höherer Target- und Bogenströme. Aufgrund der höheren Stromstärken lassen sich deutlich höhere Beschichtungsraten erzielen.

Durch die Verwendung von oxidkeramischen Sputtertargets ist es möglich, den Prozess nicht-reaktiv zu führen, wodurch eine hohe Prozessstabilität erreicht und der technische Aufwand verringert wird. Aufgrund der höheren Plasmaanregung kann der Anteil der mehrfach geladenen Teilchen und die kinetische Energie der Teilchen gesteigert werden, was eine Beschichtung ohne Substrat-Bias möglich macht. Dies führt zu verbesserten Schichteigenschaften, wie z.B. einer höheren Schichtdichte, verbesserter Haftfestigkeit, höherer elektrischer Leitfähigkeit und einer verbesserten chemischen Beständigkeit.

Die Konzentration der Elemente im Sputtertarget weicht dabei maximal um 5% von der Konzentration des jeweiligen Elements in der Schicht ab. Das erfindungsgemäße Verfahren erlaubt somit die stöchiometrische Abscheidung von keramischen, bevorzugt perowskitischen Schichten und dies auch auf ungeheizten Substraten. Die erzeugten Schichtoberflächen sind glatt und chemisch stabil.

Die Schicht wird dabei mit einer Frequenz der gepulsten Spannung von 1 bis 1000 kHz abgeschieden. Unter 1 kHz bzw. im DC Betrieb können bei der Abscheidung von dielektrischen Materialien keine stabilen Beschichtungsprozesse gefahren werden, sondern es treten elektrische Überschläge und "Arcing" auf.

Über 1000 kHz werden der technische Aufwand für die Spannungsversorgung und die notwendigen Anpassungseinheiten zur Regelung der Prozessimpedanz für eine wirtschaftliche Beschichtung zu groß. Besonders wirtschaftlich wird das Verfahren, wenn eine Frequenz von 10 bis 500 kHz, bevorzugt 100 bis 350 kHz, gewählt wird. Der Spannungseffektivwert beträgt dabei +100 bis -1000 V, bevorzugt +100 bis -500 V. Unter Spannungseffektivwert einer Wechselspannung versteht man dabei den Gleichspannungswert, der derselben Wärmewirkung entspricht. Das Verhältnis von Scheitelwert zu Effektivwert wird als Crestfaktor bezeichnet und ist für Sinusgrößen beispielsweise 1,41. Unter dem angegebenen Grenzwert sind die Teilchenenergien für den gewünschten Sputterprozess zu gering. Über dem angegebenen Grenzwert kann es aufgrund der hohen Teilchenenergien zu unerwünschten Effekten kommen, wie z.B. Absputtern der aufdampfenden Schicht, elektrische Überschläge aufgrund hoher Feldstärken, Implantation im Substrat, unerwünschte Temperaturerhöhung usw., die eine Abscheidung von Schichten mit perowskitischer Struktur verhindern.

Es hat sich als vorteilhaft erwiesen, die Schicht mit einer mittleren Leistungsdichte von 1 bis 30 W/cm² abzuscheiden.

Unter 1 W/cm² ist die Beschichtungsrate zu klein und damit die Beschichtungsdauer für eine industrielle Umsetzung zu lang. Über 30 W/cm² ist der Energieeintrag am Target zu groß, was die thermische Zerstörung des perowskitischen Targetmaterials zur Folge hat.

Als Prozessgas wird ein Inertgas, bevorzugt Argon, mit einem Druck von 1x10⁻⁴ bis 9x10⁻² mbar verwendet. Unter 1x10⁻⁴ mbar kann der Sputterprozess nicht gezündet werden. Über 9x10⁻² mbar werden die freien Weglängen der gesputterten Schichtteilchen aufgrund zu vieler Stossprozesse zu klein. Die kinetische Energie der gesputterten Schichtteilchen wird dadurch verringert, wodurch die gewünschten Schichteigenschaften nicht erzielt werden können.

Die keramische Schicht weist bevorzugt eine perowskitische Struktur auf, mit der Strukturformel ABO₃. Die Kristallstruktur ist dabei kubisch, orthorhombisch oder tetragonal. A umfasst ein oder mehrere Elemente aus der Gruppe La, Ba, Sr, Ca.

B umfasst ein oder mehrere Elemente aus der Gruppe Cr, Mg, Al, Mn, Fe, Co, Ni, Cu und Zn. Die Schichten weisen vorzugsweise eine Dichte > 99 % der theoretischen Dichte und einen Verunreinigungsgehalt < 0,5 Gew.%, bevorzugt < 0,1 Gew.% auf.

Im Folgenden wird die Erfindung durch Beispiele näher erläutert
Figur 1 zeigt schematisch die Anordnung einer perowskitischen Schicht auf einem porösen Substrat.
Figur 2 zeigt EPMA Messungen eines porösen Substrat mit LSC-Schicht und darauf abgeschiedener Ni-Schicht nach 1000 h Auslagerung bei 850°C

### Beispiel 1

Ein poröses Trägersubstrat mit einer Zusammensetzung 26 Gew.% Cr, 0,5 Gew.% Y₂O₃, 2 Gew.% Mo, 0,3 Gew.% Ti und 0,03 Gew.% Al, Rest Fe wurde mittels gepulstem, nicht reaktivem DC Prozess beschichtet. Dazu wurde ein Edwards Sputtercoater verwendet, in dem ein LSM-Target (La_{0,8}Sr_{0,2}Mn-Oxid) mit einem Durchmesser von 72 mm eingebaut wurde. Zudem wurde eine Sputterleistung von 400 W, eine Spannung von 149 V, ein Strom von 2,01 A, eine Frequenz von 350 kHz (bei einer Pulsdauer von 1,1 µs) und ein Prozessdruck von 5*10⁻³ mbar eingestellt. Damit wurden LSM Schichten mit 3 µm Dicke mit einer Zusammensetzung La_{0,8}Sr_{0,2}Mn Oxid (LSM) hergestellt.

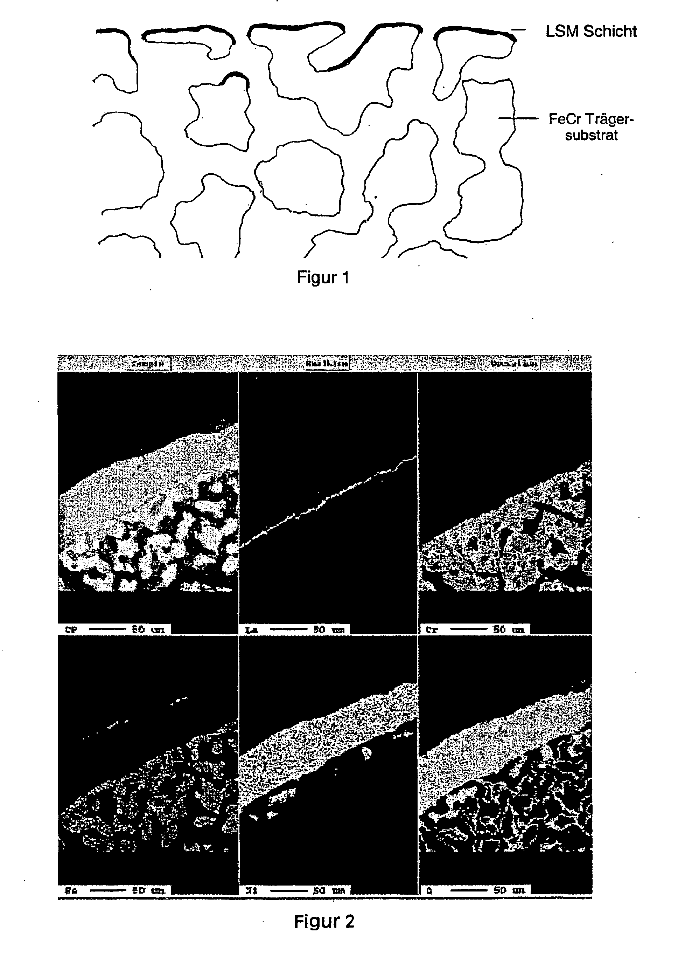

Figur 1 zeigt schematisch die Anordnung der abgeschiedenen Schichten auf dem porösen Trägersubstrat.

### Beispiel 2

Poröse und dichte Trägersubstrate mit einer Zusammensetzung 26 Gew.% Cr, 0,5 Gew.% Y₂O₃, 2 Gew.% Mo, 0,3 Gew.% Ti und 0,03 Gew.% Al, Rest Fe wurde mittels gepulstem, nicht reaktivem DC Prozess beschichtet. Dazu wurde ein Edwards Sputtercoater verwendet, in dem ein LSC-Target (La_{0,8}Sr_{0,2}Cr-Oxid) mit einem Durchmesser von 72 mm eingebaut wurde. Zudem wurde eine Sputterleistung von 400 W, eine Spannung von 149 V, ein Strom von 2,01 A, eine Frequenz von 350 kHz (bei einer Pulsdauer von 1,1 µs) und ein Prozessdruck von 5*10⁻³ mbar eingestellt. Damit wurden LSC-Schichten mit 3 µm Dicke mit einer Zusammensetzung La_{0,8}Sr_{0,2}CrO₃ hergestellt.

Die LSC-Schichten wurden anschließend mit einer 50 µm dicken APS Nickelschicht überzogen. Dieser Aufbau, Eisenchromlegierung (porös und nicht-porös) - LSC-Schicht (3 µm) - APS Nickelschicht (50 µm) diente zur Untersuchung der Diffusionsbarrierwirkung der dünnen LSC-Schicht gegenüber Nickel in Eisen bzw. Eisen in Nickel. Der Aufbau wurde dabei bei 850°C bis 1000°C an Luft für 100 h ausgelagert. Die Diffusionseigenschaften wurden mit Hilfe von EPMA Messungen dokumentiert (Figur 2). Die LSC-Schicht verhindert bei den gegebenen Testbedingungen eine Diffusion von Nickel in Eisen bzw. Eisen in Nickel. Die abgeschiedenen LSC-Schichten weisen eine hohe elektrische Leitfähigkeit (dem verwendeten Target entsprechend), eine hohe Dichte von > 99,9 %, einen homogenen Schichtaufbau und eine glatte Oberfläche mit einem Mittelrauwert gleich dem Substrat-Mittelrauwert auf. Prozessbedingt sind keine Einlagerungen von Fremdatomen mittels EPMA und EDX messbar.

## Patentansprüche

1. Verfahren zur Herstellung einer elektrisch leitfähigen keramischen Schicht auf einem porösen Trägersubstrat, wobei das Trägersubstrat eine Dichte von 40 bis 70 % der theoretischen Dichte und eine überwiegend offenporige Struktur aufweist,
**dadurch gekennzeichnet,**
**dass** die Schicht durch einen gepulsten Sputterprozess unter Erhaltung der überwiegend offenporigen Struktur des Trägersubstrats auf diesem abgeschieden wird, wobei sich heine geschlossene Dechscicht ausbildet.

2. Verfahren nach Anspruch 1, **dadurch gekennzeichnet, dass** die Schicht eine perowskitische Struktur aufweist.

3. Verfahren nach Anspruch 1 oder 2, **dadurch gekennzeichnet, dass** ein oxidkeramisches Sputtertarget eingesetzt wird.

4. Verfahren nach einem der Ansprüche 1 bis 3, **dadurch gekennzeichnet, dass** die Konzentration der Elemente im Sputtertarget maximal um 5% von der Konzentration des jeweiligen Elements in der Schicht abweicht.

5. Verfahren nach einem der Ansprüche 1 bis 4, **dadurch gekennzeichnet, dass** die Schicht mit einer Frequenz der gepulsten Spannung von 1 bis 1000 kHz abgeschieden wird.

6. Verfahren nach Anspruch 5, **dadurch gekennzeichnet, dass** die Schicht mit einer Frequenz der gepulsten Spannung von 10 bis 500 kHz abgeschieden wird.

7. Verfahren nach Anspruch 6, **dadurch gekennzeichnet, dass** die Schicht mit einer Frequenz der gepulsten Spannung von 100 bis 350 kHz abgeschieden wird.

8. Verfahren nach einem der Ansprüche 1 bis 7, **dadurch gekennzeichnet, dass** die Schicht mit einem Spannungseffektivwert von +100 bis -1000 V abgeschieden wird.

9. Verfahren nach Anspruch 8, **dadurch gekennzeichnet, dass** die Schicht mit einem Spannungseffektivwert von +100 bis -500 V abgeschieden wird.

10. Verfahren zur nach einem der Ansprüche 1 bis 9, **dadurch gekennzeichnet, dass** die Schicht mit einer mittleren Leistungsdichte von 1 bis 30 W/cm² abgeschieden wird.

11. Verfahren nach einem der Ansprüche 1 bis 10, **dadurch gekennzeichnet, dass** als Prozessgas ein Inertgas, bevorzugt Argon, mit einem Druck von 1x10⁻⁴ bis 9x10⁻² mbar verwendet wird.

12. Verfahren nach einem der Ansprüche 1 bis 11, **dadurch gekennzeichnet, dass** die Schicht eine Strukturformel ABO₂ aufweist, wobei A ein oder mehrere Elemente aus der Gruppe La, Ba, Sr, Ca und B ein oder mehrere Elemente aus der Gruppe Cr, Mg, Al, Mn, Fe, Co, Ni, Cu, Zn umfasst.

13. Verfahren nach einem der Ansprüche 1 bis 12, **dadurch gekennzeichnet, dass** eine Schicht mit einer Dicke von 0,1 bis 5 µm abgeschieden wird.

14. Verfahren nach einem der Ansprüche 1 bis 13, **dadurch gekennzeichnet, dass** eine Schicht mit einer Dichte von > 99 % der theoretischen Dichte abgeschieden wird.

15. Verfahren nach einem der Ansprüche 1 bis 14, **dadurch gekennzeichnet, dass** eine Schicht mit einem Verunreinigungsgehalt < 0,5 Gew.%, bevorzugt < 0,1 Gew.% abgeschieden wird.

16. Verfahren nach einem der Ansprüche 1 bis 15, **dadurch gekennzeichnet, dass** das poröse Trägersubstrat in einer SOFC Brennstoffzelle eingesetzt wird.

17. Poröses Trägersubstrat mit einer Dichte von 40 bis 70 % der theoretischen Dichte und einer überwiegend offenporigen Struktur, bestehend aus miteinander versinterten Körnern einer Fe-Basis Legierung mit 15 bis 35 Gew.% Cr; 0,01 bis 2 Gew.% eines oder mehrerer Elemente der Gruppe Ti, Zr, Hf, Mn, Y, Sc, Seltenerdmetalle; 0 bis 10 Gew.% Mo und / oder Al; 0 bis 5 Gew.% eines oder mehrerer Metalle der Gruppe Ni, W, Nb, Ta; 0,1 bis 1 Gew.% O, Rest Fe und Verunreinigungen,
**dadurch gekennzeichnet**
**dass** auf diesem eine elektrisch leitfähige keramische PVD Schicht mit einer Dicke von 0,1 bis 5 µm unter Erhaltung der überwiegend offenporigen Struktur abgeschieden ist, wobei sich keine geschlossene Deckschicht ausbildet.

## Claims

1. Process for producing an electrically conductive ceramic layer on a porous support substrate, wherein the support substrate has a density of 40 to 70% of the theoretical density and a predominantly open-pored structure,
**characterized**
**in that** the layer is deposited on the support substrate by a pulsed sputtering process, while retaining the predominantly open-pored structure of said support substrate, with no closed top layer being formed.

2. Process according to Claim 1, **characterized in that** the layer has a perovskitic structure.

3. Process according to Claim 1 or 2, **characterized in that** an oxide-ceramic sputtering target is used.

4. Process according to one of Claims 1 to 3, **characterized in that** the concentration of the elements in the sputtering target differs at most by 5% from the concentration of the respective element in the layer.

5. Process according to one of Claims 1 to 4, **characterized in that** the layer is deposited at a frequency of the pulsed voltage of 1 to 1000 kHz.

6. Process according to Claim 5, **characterized in that** the layer is deposited at a frequency of the pulsed voltage of 10 to 500 kHz.

7. Process according to Claim 6, **characterized in that** the layer is deposited at a frequency of the pulsed voltage of 100 to 350 kHz.

8. Process according to one of Claims 1 to 7, **characterized in that** the layer is deposited with a voltage root-mean-square value of +100 to -1000 V.

9. Process according to Claim 8, **characterized in that** the layer is deposited with a voltage root-mean-square value of +100 to -500 V.

10. Process according to one of Claims 1 to 9, **characterized in that** the layer is deposited with a mean power density of 1 to 30 W/cm².

11. Process according to one of Claims 1 to 10, **characterized in that** the process gas used is an inert gas, preferably argon, with a pressure of 1x10⁻⁴ to 9x10⁻² mbar.

12. Process according to one of Claims 1 to 11, **characterized in that** the layer has the structural formula ABO₂, where A comprises one or more elements selected from the group consisting of La, Ba, Sr, Ca, and B comprises one or more elements selected from the group consisting of Cr, Mg, Al, Mn, Fe, Co, Ni, Cu, Zn.

13. Process according to one of Claims 1 to 12, **characterized in that** a layer with a thickness of 0.1 to 5 µm is deposited.

14. Process according to one of Claims 1 to 13, **characterized in that** a layer with a density >99% of the theoretical density is deposited.

15. Process according to one of Claims 1 to 14, **characterized in that** a layer with an impurity content <0.5% by weight, preferably <0.1% by weight, is deposited.

16. Process according to one of Claims 1 to 15, **characterized in that** the porous support substrate is used in a solid oxide fuel cell (SOFC).

17. Porous support substrate which has a density of 40 to 70% of the theoretical density and a predominantly open-pored structure and consists of sintered grains of an Fe-based alloy comprising 15 to 35% by weight Cr, 0.01 to 2% by weight of one or more elements selected from the group consisting of Ti, Zr, Hf, Mn, Y, Sc, rare earths, 0 to 10% by weight Mo and/or Al, 0 to 5% by weight of one or more metals selected from the group consisting of Ni, W, Nb, Ta, 0.1 to 1% by weight O, remainder Fe and impurities, **characterized in that** an electrically conductive ceramic PVD layer with a thickness of 0.1 to 5 µm is deposited on said porous support substrate while retaining the predominantly open-pored structure, with no closed top layer being formed.

## Revendications

1. Procédé de fabrication d'une couche céramique électriquement conductrice sur un substrat porteur poreux, où le substrat porteur a une densité de 40 à 70% de la densité théorique et une structure majoritairement à pores ouverts,
**caractérisé en ce que** ladite couche est déposée sur le substrat porteur par un procédé de pulvérisation cathodique pulsée en conservant la structure majoritairement à pores ouverts du substrat porteur sans qu'il se forme de couche de couverture fermée.

2. Procédé selon la revendication 1, **caractérisé en ce que** ladite couche céramique présente une structure de pérovskite.

3. Procédé selon la revendication 1 ou 2, **caractérisé en ce que** l'on utilise une cible de pulvérisation cathodique en oxyde céramique.

4. Procédé selon l'une quelconque des revendications 1 à 3, **caractérisé en ce que** la concentration des éléments dans la cible de pulvérisation cathodique s'écarte au maximum de 5% de la concentration des éléments correspondants dans la couche céramique.

5. Procédé selon l'une quelconque des revendications 1 à 4, **caractérisé en ce que** le dépôt de la couche céramique s'effectue sous une fréquence de tension pulsée de 1 à 1000 kHz.

6. Procédé selon la revendication 5, **caractérisé en ce que** le dépôt de la couche céramique s'effectue sous une fréquence de tension pulsée de 10 à 500 kHz.

7. Procédé selon la revendication 6, **caractérisé en ce que** le dépôt de la couche céramique s'effectue sous une fréquence de tension pulsée de 100 à 350 kHz.

8. Procédé selon l'une quelconque des revendications 1 à 7, **caractérisé en ce que** le dépôt de la couche céramique s'effectue sous une valeur de tension effective allant de + 100 à -1000 V.

9. Procédé selon la revendication 8, **caractérisé en ce que** le dépôt de la couche céramique est effectué sous une valeur de tension effective comprise entre +100 et -500 V.

10. Procédé selon l'une quelconque des revendications 1 à 9, **caractérisé en ce que** le dépôt de la couche céramique est effectué avec une puissance spécifique surfacique moyenne de 1 à 30 W/cm^{2.}

11. Procédé selon l'une quelconque des revendications 1 à 10, **caractérisé en ce que** l'on utilise comme gaz de traitement un gaz inerte, de préférence constitué d'argon, sous une pression de 1 x 10⁻⁴ à 9 x 10⁻² mbar.

12. Procédé selon l'une quelconque des revendications 1 à 11, **caractérisé en ce que** la couche céramique présente une structure de la forme ABO₂, où A représente un ou plusieurs éléments pris dans le groupe La, Ba, Sr, Ca tandis que B représente un ou plusieurs éléments pris dans le groupe Cr, Mg, Al, Mn, Fe, Co, Ni, Cu, Zn.

13. Procédé selon l'une quelconque des revendications 1 à 12, **caractérisé en ce que** la couche céramique est déposée sous une épaisseur de 0,1 à 5 µm.

14. Procédé selon l'une quelconque des revendications 1 à 13, **caractérisé par** le dépôt d'une couche dont la densité est supérieure à 99 % de la densité théorique.

15. Procédé selon l'une quelconque des revendications 1 à 14, **caractérisé par** le dépôt d'une couche dont la teneur en impuretés est inférieure à 0,5% en poids, et de préférence inférieure à 0,1 % en poids.

16. Procédé selon l'une quelconque des revendications 1 à 15, **caractérisé en ce que** le substrat porteur poreux est mis en oeuvre dans une pile à combustible SOFC (pile combustible à oxyde solide).

17. Substrat porteur poreux d'une densité comprise entre 40 et 70% de la densité théorique et à structure majoritairement à pores ouverts, constitué de grains co-frittés d'un alliage à base de Fe comportant de 15 à 35 % en poids de Cr, de 0,01 à 2 % en poids d'un ou de plusieurs éléments du groupe Ti, Zr, Hf, Mn, Y, Sc, terres rares, de 0 à 10 % en poids de Mo et / ou Al, de 0 à 5 % en poids d'un ou plusieurs métaux du groupe Ni, W, Nb, Ta, de 0,1 à 1 % en poids de O, le reste étant composé de Fe et d'impuretés,
**caractérisé en ce qu'**il est revêtu d'une couche céramique électriquement conductrice déposée sous vide par PVD (dépôt physique en phase vapeur) sous une épaisseur comprise entre 0,1 et 5 µm, avec préservation de la structure majoritairement à pores ouverts sans formation de couche de couverture fermée.
